# EUROPÄISCHE PATENTSCHRIFT

(11) **EP 2 156 143 B1**
(45) Veröffentlichungstag und Bekanntmachung des Hinweises auf die Patenterteilung: **15.02.2012**
(21) Anmeldenummer: 08736108.5
(22) Anmeldetag: 11.04.2008
(51) Int. Cl.: G01D 5/14, G01R 33/09, B82Y 25/00

(54) **MAGNETFELDSENSOR**
MAGNETIC FIELD SENSOR
CAPTEUR DE CHAMP MAGNÉTIQUE

(30) Priorität: 04.06.2007 DE 102007025965
(43) Veröffentlichungstag der Anmeldung: 24.02.2010
(73) Patentinhaber: Robert Bosch GmbH, 70442 Stuttgart (DE)
(72) Erfinder: BAUER, Christian, 71701 Schwieberdingen (DE)
(86) Internationale Anmeldenummer: PCT/EP2008/054393
(87) Internationale Veröffentlichungsnummer: WO 2008/148600

(56) Entgegenhaltungen:
- DE-A1- 10 357 149
- DE-A1- 19 850 460
- US-A1- 2006 072 249
- US-B1- 6 184 680
- US-B1- 6 329 818

## Beschreibung

### Stand der Technik

Die Erfindung geht aus von einem Magnetfeldsensor zur berührungslosen Erfassung einer Rotations- oder Linearbewegung nach der Gattung des unabhängigen Anspruchs. Ein derartiger Sensor ist aus der DE 103 57 149 A1 bekannt in der Verwendung beispielsweise als robuster Sensor für die Drehzahlerfassung in Kraftfahrzeugen. Der beschriebene Sensor ist als GMR(Giant Magneto Resistance)-Sensor ausgebildet mit mindestens einem Sensorelement aus einem magnetfeldempfindlichen Schichtsystem aus dünnen, abwechselnd magnetischen und nicht magnetischen Metallschichen, welches eine starke Abhängigkeit des elektrischen Widerstandes von einem angelegten äußeren Magnetfeld aufgrund spinabhängiger Elektrodenstreuung aufweist. Vorzugsweise sind dabei mehrere magnetfeldempfindliche Sensorelemente zu einer Messbrücke verschaltet, wobei die Sensorelemente aus mindestens einem weitgehend linearen Messstreifen gebildet sind, der sich im Wesentlichen senkrecht zur Richtung des zu erfassenden Magnetfeldes erstreckt.

Magnetfeldsensoren der zuvor erörterten Art finden in vielen technischen Bereichen Anwendung, bei denen eine berührungsfreie Detektierung einer Bewegung gewünscht ist. Der Sensor erfasst die Änderung der magnetischen Flussdichte im Spalt zwischen einem Versorgungsmagneten und einem ferromagnetischen Geberelement in Abhängigkeit von der Position des Geberelementes, wobei eine exakte Positionierung des Sensorelementes gegenüber dem die Magnetisierung im Spalt erzeugenden Dauermagneten und gegenüber dem Geberelement für das Messergebnis wichtig ist. Dabei werden vorzugsweise Sonderbauformen von Permanentmagneten benutzt, insbesondere sogenannte Spaltmagnete mit oder ohne Streuscheibe zur Harmonisierung des Magnetfeldes. Derartige Anordnungen sind beispielsweise aus der DE 10 2004 063 539 A1 ebenfalls bekannt und brauchen hier nicht detailliert erörtert werden.

### Offenbarung der Erfindung

Der erfindungsgemäße Magnetfeldsensor mit den Merkmalen des unabhängigen Anspruchs hat gegenüber bekannten Vorrichtungen den Vorteil, dass das Sensorelement relativ zu dem Versorgungsmagneten mit geringem Aufwand präzise positioniert werden kann, wodurch insbesondere vermieden wird, dass Sättigungseffekte in dem Sensorelement auftreten und das Nutzsignal verringert wird. Außerdem ermöglicht die vorgeschlagene Anordnung die Kontrolle der Einbaulage des Sensorelementes und des zugeordneten Permanentmagneten gegenüber einem Geberelement, beispielsweise in einem Kraftfahrzeug. Damit wird die einwandfreie Funktion übergeordneter Baugruppen, beispielsweise des Bremssystems eines Fahrzeuges, gewährleistet.

Erfindungsgemäß ist dabei eine Anordnung, bei der auf einem Sensorchip in y-Richtung eines x/y/z-Koordinatensystems symmetrisch zu dem in der x-Messrichtung ausgerichteten magnetoresistiven Messelementes jeweils mindestens ein weiteres magnetoresistives Positionierelement angeordnet ist. Auf diese Weise können Ungenauigkeiten bei der Ausrichtung des Sensorelementes senkrecht zur Messrichtung präzise als Differenzsignale erfasst werden, wobei sich im Idealfall bei korrekter Ausrichtung die y-Komponenten der durch den Versorgungsmagnet erzeugten Flussdichte zu Null addieren. Aus einer positiven oder negativen Differenz kann auch sofort die Richtung der Fehlpositionierung erkannt werden.

Durch die in den abhängigen Ansprüchen aufgeführten Maßnahmen sind vorteilhafte Weiterbildungen und Verbesserungen der im unabhängigen Anspruch angegebenen Vorrichtung möglich.

Vorzugsweise sind alle magnetoresistiven Sensorelemente als Spin-Valve-Elemente ausgebildet, weil diese in der Lage sind, auch sehr kleine Feldstärkemodulationen zu erfassen. Diese Ausführung gewährleistet daher eine hohe Empfindlichkeit der Sensoren und lässt größere Toleranzen der Luftspaltbreite zwischen der Anordnung aus Sensorelementen und Dauermagnet und dem benachbarten ferromagnetischen Geberelement zu.

### Kurze Beschreibung der Zeichnungen

Ausführungsbeispiele der Erfindung sind in den Zeichnungen dargestellt und in der nachfolgenden Beschreibung näher erläutert.

Es zeigen
- Figur 1: eine perspektivische Darstellung eines Magnetfeldsensors mit in der Messrichtung x eines dreidimensionalen x/y/z-Koordinatensystems ausgerichtetem Dauermagneten, Sensorchip und ferromagnetischem Geberelement,
- Figur 2: eine perspektivische Darstellung eines in der x/y-Ebene eines dreidimensionalen x/y/z-Koordinatensystems angeordneten, erfindungsgemäßen Sensorchips,
- Figur 3: zwei schematische Darstellungen der Ausrichtung des Sensorchips zum Versorgungsmagneten, jeweils in der z/y-Ebene des Koordinatensystems, mit einer exakten mittigen Anordnung des Sensorchips in der Darstellung a) und einer in y-Richtung versetzten Anordnung des Sensorchips gegenüber dem Dauermagnet der Darstellung b) und
- Figur 4: drei Kennlinien des magnetoresistiven Widerstandes GMR in Abhängigkeit der Flussdichte B in Messrichtung bei unterschiedlich großen magnetischen Querfeldern.

### Ausführungsform der Erfindung

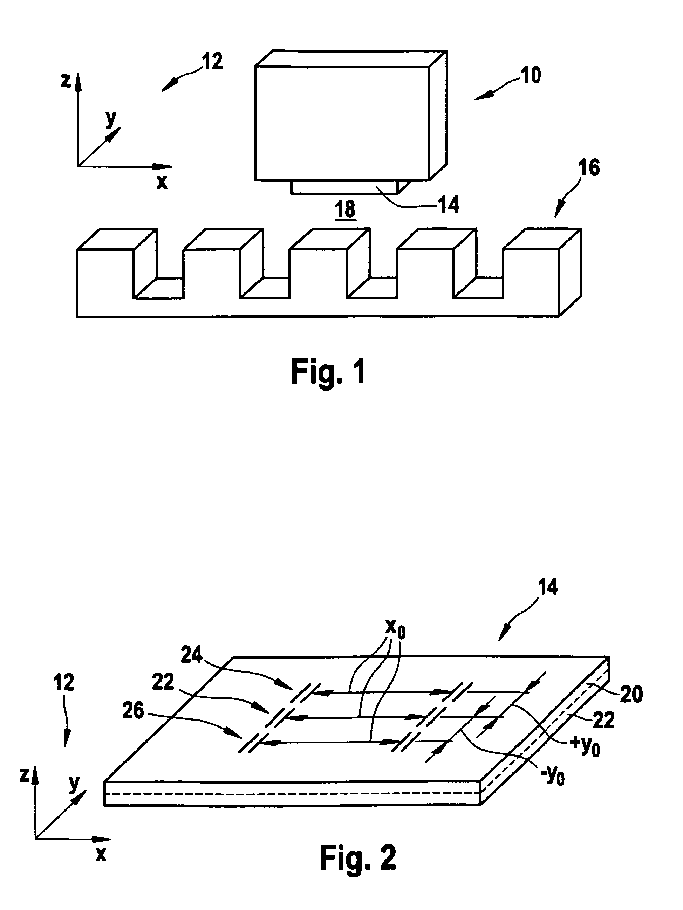

In Figur 1 ist das Prinzip eines Magnetfeldsensors dargestellt zur berührungslosen Erfassung einer Rotations-oder Linearbewegung, wie er beispielsweise als Drehzahlsensor im Antriebsstrang oder an den Rädern von Kraftfahrzeugen zum Einsatz kommt. Die schematisierte Darstellung zeigt einen ortsfesten Dauermagneten 10, welcher in z-Richtung eines dreidimensionalen x/y/z-Koordinatensystems 12 magnetisiert ist. Mit dem Dauermagnet 10 ist ein Sensorchip 14 fest verbunden, welcher eine Mehrzahl von GMR(Giant Magneto Resistance)-Sensorelementen und eine Auswerteschaltung enthält. Die zu detektierende Bewegung in x-Richtung des Koordinatensystems 12 wird mit einem ferromagnetischen Geberelement 16 erfasst, welches entweder in der dargestellten geraden Zahnstangenform zur Erfassung einer Linearbewegung oder als Zahnrad zur Erfassung einer Rotationsbewegung ausgebildet ist. Durch eine Bewegung des Geberelementes 16 wird der magnetische Fluss im Luftspalt 18 zwischen dem das Magnetfeld erzeugenden Dauermagnet 10 und dem Geberelement 16 entsprechend der Form des Geberelementes moduliert, so dass bei der Bewegung des Geberelementes der veränderliche Feldstärkeverlauf als Maß für die Bewegung oder für eine veränderte Position durch den Sensorchip 14 erfasst werden kann.

Figur 2 zeigt in ebenfalls schematisierter Darstellung die Messanordnung des Sensorchips 14, welche in eine Oberschicht 20, getrennt von einer in der Zeichnung nicht dargestellten, in eine Unterschicht 22 eingebetteten Auswerteschaltung angeordnet ist. Die Messanordnung enthält insgesamt zwölf, jeweils als kurze Linien dargestellte Schichtsysteme, wovon jeweils vier in Form einer Wheatstone-Brücke in bekannter Weise verschaltet sind. Hierbei bildet die in der Mitte liegende Messbrücke das eigentliche Messelement 22. Beidseitig des Messelementes 22 liegen ein erstes Positionierelement 24 und ein zweites Positionierelement 26, welche in gleicher Weise wie das Messelement 22 Veränderungen des Feldstärkeverlaufs detektieren und entsprechend der gemessenen Feldstärke einen Messwert für die Fehlpositionierung des Sensorchips 14 liefern. Hierbei ist der seitliche Abstand der Positionierelemente 24 und 26 in y-Richtung des Koordinatensystems 12 zum mittig angeordneten Messelement 22 jeweils gleich groß und mit +yₒ/-y₀ bezeichnet. In der Messrichtung x des Koordinatensystems 12 haben die paarweise angeordneten Schichtsysteme der drei Sensorelemente 22, 24 und 26 jeweils den gleichen Abstand x₀ und sind jeweils in x-Richtung auf gleicher Höhe angeordnet, so dass sich eine symmetrische Anordnung zu der mittleren Messbrücke des Messelementes 22 ergibt. Anstelle der in Figur 2 gezeigten Brückenanordnung kann jedoch auch eine einfache Differenzmessung durchgeführt werden mit zwei Messelementen oder es genügt sogar ein einziges zusätzliches Sensorelement, wenn die Differenz zum Messelement 22 in geeigneter Weise ausgewertet wird.

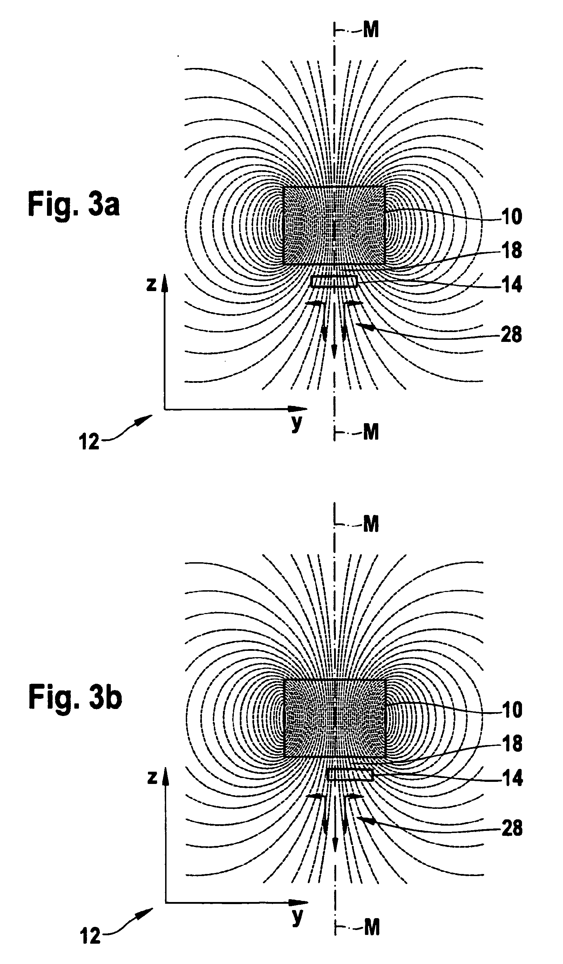

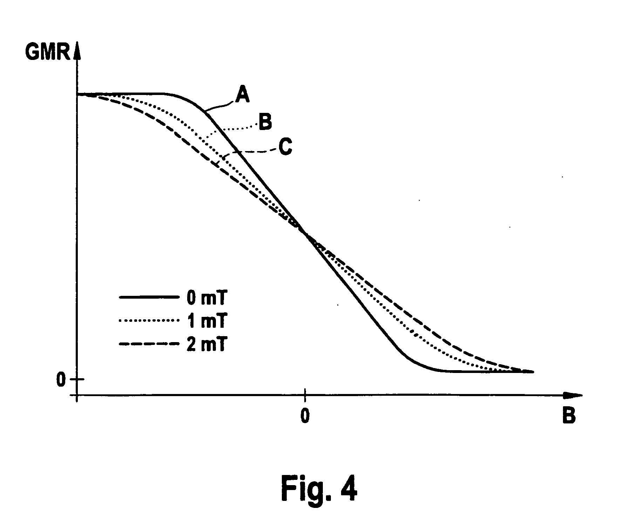

Figur 3a zeigt die korrekte mittige Lage des Sensorchips 14 zum Dauermagnet 10. Die Symmetrieebene des Dauermagneten ist mit M bezeichnet. Das Pfeilebündel 28 bezeichnet dabei die jeweiligen Komponenten der magnetischen Flussdichte in der y/z-Ebene. Die Figur 3b zeigt dagegen eine Anordnung mit einem aus der Mitte des Dauermagneten 10 in y-Richtung des Koordinatensystems 12 verschobenen Sensorchip 14, wobei aus der Lage des Sensorchips 14 gegenüber dem Pfeilebündel 28 deutlich die Veränderung der magnetischen Flussdichte ersichtlich ist. Auf die Darstellung der einzelnen Sensorelemente 22, 24 und 26 ist in dieser Ansicht aus Gründen der Übersichtlichkeit verzichtet worden. Während in der Darstellung von Figur 3a) am Ort des nicht gezeigten Messelementes 22 die y-Komponenten der magnetischen Flussdichte, die durch den Dauermagnet 10 erzeugt werden, im Idealfall =0 sind, wächst die By-Komponente entsprechend der Anordnung in Figur 3b) umso stärker an, je weiter sich die Position in +y- oder -y-Richtung von der Symmetrieebene des Dauermagneten 10 entfernt. Hierdurch wird in den GMR-Messbrücken 24 und 26 entsprechend der Größe der By-Komponenten die Messempfindlichkeit reduziert, wie dies anhand der Figur 4 noch erläutert wird.

Bringt man entsprechend den Darstellungen in den Figuren 2 und 3 eine zusätzliche Messbrücke in Form der Positionierelemente 24 oder 26 in einem Abstand y₀ von der Symmetrieebene des Dauermagneten 10 an, so erhält man von dieser Messbrücke beim Vorbeibewegen des Geberelementes 16 ein Signal, das in seiner Amplitude gegenüber dem Signal der eigentlichen Messbrücke in Form des Messelementes 22 um einen bestimmten Faktor reduziert ist. Ist eine weitere Messbrücke in Form des zweiten Positionierelementes 26 in einem Abstand -y₀ symmetrisch zur Mitte des Dauermagneten 10 vorhanden, so erhält man bei idealer Positionierung des Sensorchips 14 von dieser weiteren Messbrücke in Form des zweiten Positionierelementes 26 ein Signal, welches beim Vorbeibewegen eines Zahns des Geberelementes 16 exakt gleich dem Signal der ersten Messbrücke des ersten Positionierelementes 24 ist. Ist dagegen der Sensorchip 14 und das GMR-Messelement 22 in y-Richtung nicht optimal positioniert, so sind die beiden Signale der zusätzlichen Positionierelemente 24 und 26 unterschiedlich und es lässt sich durch die Auswertung der Signale der zwei zusätzlichen Sensorelemente 24 und 26 die Position des Messelementes 22 exakt bestimmen und einstellen. Wenn hierbei die Amplituden der Signale aus den Positionierelementen 24 und 26 in der nicht dargestellten Auswerteschaltung des Sensorchips 14 die gleichen Schaltschwellen aufweisen wie bei den Signalen des Messelementes 22, so kann mit den zusätzlichen Positionierelementen 24 und 26 ein geringerer Grenzluftspalt, das heißt ein früherer Signalabriss als beim Hauptsignal erreicht werden. Im Umkehrschluss garantiert das Erreichen der Schaltschwellen eines der zusätzlichen Positionierelemente 24 oder 26 immer eine hohe Messsicherheit für das ursprüngliche Messsignal des Sensorelementes 22.

Durch geeignete Gestaltung des Dauermagneten 10 und der Abstände y₀ können entsprechend den jeweiligen Anforderungen definierte Sicherheiten realisiert werden, mit denen die korrekte Luftspaltposition des GMR-Messelementes 22 gegenüber dem Geberelement 16 kontrolliert werden kann. Umgekehrt ist es auch möglich, mit Hilfe der Signale der zusätzlichen Positionierelemente 24 und 26 den korrekten Einbau des Geberelementes 16 zum Sensorchip 14 mit dem GMR-Messelement 22 zu kontrollieren.

In der Darstellung der Figur 4 ist für die bevorzugte Verwendung von GMR-Spin-Valve-Sensorelementen 22, 24 und 26 der Zusammenhang zwischen dem GMR-Effekt und der magnetischen Flussdichte B dargestellt. Hierbei zeigen die Kennlinien A, B und C die Änderung des GMR-Effekts bei Querfeldern in y-Richtung von 0 mT, 1 mT und 2 mT in Abhängigkeit der Flussdichte B des Messfeldes in x-Richtung. Die Reduzierung der Messempfindlichkeit des GMR-Sensorelementes bei außermittiger Anordnung ist aus dieser Darstellung deutlich zu erkennen.

## Patentansprüche

1. Magnetfeldsensor zur berührungslosen Erfassung einer Rotations- oder Linearbewegung, insbesondere Drehzahlsensor und/oder Positionssensor für den Antriebsstrang eines Kraftfahrzeuges und/oder zur Erfassung einer Raddrehzahl, mit einem ortsfesten, in z-Richtung eines dreidimensionalen x/y/z-Koordinatensystems(12) magnetisierten Dauermagneten (10), mit einem dem Dauermagneten (10) zugeordneten Sensorchip (14) mit wenigstens einem magnetoresistiven Sensorelement, insbesondere einem GMR, d. h. Giant Magneto Resistance-Sensorelement (22), und mit einem in Messrichtung, d. h. x-Richtung, beweglichen ferromagnetischen Geberelement (16), welches bei der Bewegung einen veränderlichen Feldstärkeverlauf in dem Sensorelement erzeugt, wobei auf dem Sensorchip (14) zur Positionierung gegenüber dem Dauermagneten (10) und/oder dem Geberelement (16) wenigstens ein weiteres, gegenüber dem ersten Sensorelement in y-Richtung verschobenes magnetoresistives Sensorelement (24,26) angeordnet ist, **dadurch gekennzeichnet, dass** auf dem Sensorchip (14) in y-Richtung des Koordinatensystems (12) beidseitig des magnetoresistiven Messelementes (22) jeweils mindestens ein weiteres magnetoresistives Positionierelement (24,26) sitzt, wobei durch eine Auswertung von Signalen des jeweils mindestens einen weiteren Positionierelements (24, 26) eine Position des magnetoresistiven Messelements (22) bestimmbar und einstellbar ist.

2. Magnetfeldsensor nach Anspruch 1, **dadurch gekennzeichnet, dass** die weiteren magnetoresistiven Sensorelemente (24,26) jeweils symmetrisch im gleichen Abstand (y₀) zum Messelement (22) angeordnet sind.

3. Magnetfeldsensor nach einem der vorhergehenden Ansprüche, **dadurch gekennzeichnet, dass** die weiteren Sensorelemente (24,26) in Messrichtung (x) auf gleicher Höhe wie das Messelement (22) angeordnet sind.

4. Magnetfeldsensor nach einem der vorhergehenden Ansprüche, **dadurch gekennzeichnet, dass** die magnetoresistiven Sensorelemente (22,24,26) als GMR-Spin-Valve-Elemente ausgebildet sind.

5. Magnetfeldsensor nach einem der vorhergehenden Ansprüche, **dadurch gekennzeichnet, dass** die Sensorelemente (22,24,26) jeweils vier, zu einer Wheatstone-Brücke verschaltete Messwiderstände aufweisen.

6. Magnetfeldsensor nach einem der vorhergehenden Ansprüche, **dadurch gekennzeichnet, dass** das Messelement (22) des Sensorchips (14) in der Symmetrieebene (M) des Dauermagneten (10) angeordnet ist.

7. Magnetfeldsensor nach einem der vorhergehenden Ansprüche, **dadurch gekennzeichnet, dass** alle Sensorelemente (22,24,26) auf einem Sensorchip (14) in einer Ebene (20) oberhalb der Ebene (22) der Auswerteschaltung angeordnet sind.

## Claims

1. Magnetic field sensor for contactlessly detecting a rotational or linear movement, in particular rotational speed sensor and/or position sensor for the drivetrain of a motor vehicle and/or for detecting a wheel rotational speed, comprising a stationary permanent magnet (10) magnetized in the z-direction of a three-dimensional x/y/z coordinate system (12), comprising a sensor chip (14) assigned to the permanent magnet (10) and comprising at least one magnetoresistive sensor element, in particular a GMR, i.e. giant magneto resistance, sensor element (22), and comprising a ferromagnetic transmitter element (16), which is movable in the measurement direction, i.e. x-direction, and which generates a variable field strength profile in the sensor element during the movement, wherein at least one further magnetoresistive sensor element (24, 26) displaced in the y-direction relative to the first sensor element is arranged on the sensor chip (14) for positioning relative to the permanent magnet (10) and/or the transmitter element (16), **characterized in that** in each case at least one further magnetoresistive positioning element (24, 26) is seated on the sensor chip (14) in the y-direction of the coordinate system (12) on both sides of the magnetoresistive measuring element (22), wherein a position of the magnetoresistive measuring element (22) can be determined and set by means of an evaluation of signals of the respective at least one further positioning element (24, 26).

2. Magnetic field sensor according to Claim 1, **characterized in that** the further magnetoresistive sensor elements (24, 26) are in each case arranged symmetrically at the same distance (y₀) with respect to the measuring element (22).

3. Magnetic field sensor according to either of the preceding claims, **characterized in that** the further sensor elements (24, 26) are arranged at the same level as the measuring element (22) in the measurement direction (x).

4. Magnetic field sensor according to any of the preceding claims, **characterized in that** the magnetoresistive sensor elements (22, 24, 26) are embodied as GMR spin valve elements.

5. Magnetic field sensor according to any of the preceding claims, **characterized in that** the sensor elements (22, 24, 26) have in each case four measuring resistors interconnected to form a Wheatstone bridge.

6. Magnetic field sensor according to any of the preceding claims, **characterized in that** the measuring element (22) of the sensor chip (14) is arranged in the plane (M) of symmetry of the permanent magnet (10).

7. Magnetic field sensor according to any of the preceding claims, **characterized in that** all the sensor elements (22, 24, 26) are arranged on a sensor chip (14) in a plane (20) above the plane (22) of the evaluation circuit.

## Revendications

1. Détecteur de champ magnétique, en particulier détecteur de vitesse de rotation et/ou détecteur de position pour le train d'entraînement d'un véhicule automobile destiné à saisir sans contact un déplacement de rotation ou un déplacement linéaire et/ou à saisir la vitesse de rotation d'une roue, et présentant
un aimant permanent (10) fixe, magnétisé dans la direction z d'un système tridimensionnel (12) de coordonnées x/y/z,
une puce de détecteur (14) associée à l'aimant permanent (10) et présentant au moins un élément magnétorésistif, en particulier un GMR, c'est-à-dire un élément de détecteur (22) dit "Giant Magneto Resistance" à magnétorésistance géante, et
un élément émetteur ferromagnétique (16) mobile dans la direction de mesure, c'est-à-dire la direction x, et qui produit lors du déplacement une évolution variable de l'intensité du champ dans l'élément de détecteur,
au moins un autre élément détecteur magnétorésistif (24, 26) décalé dans la direction y par rapport au premier élément de détecteur étant disposé sur la puce de détecteur (14) pour assurer le positionnement vis-à-vis de l'aimant permanent (10) et/ou de l'élément émetteur (16),
**caractérisé en ce que**
au moins un autre élément magnétorésistif de positionnement (24, 26) est posé sur la puce de détecteur (14) de chaque côté de l'élément magnétorésistif de mesure (22) dans la direction y du système de coordonnées (12) et
**en ce qu'**une évaluation des signaux de l'au moins un autre élément de positionnement (24, 26) respectif détermine et ajuste la position de l'élément magnétorésistif de mesure (22).

2. Détecteur de champ magnétique selon la revendication 1, **caractérisé en ce que** les autres éléments magnétorésistifs de détecteur (24, 26) sont disposés symétriquement et à même distance (y₀) par rapport à l'élément de mesure (22).

3. Détecteur de champ magnétique selon l'une des revendications précédentes, **caractérisé en ce que** les autres éléments de détecteur (24, 26) sont disposés dans la direction de mesure (x) à la même hauteur que l'élément de mesure (22).

4. Détecteur de champ magnétique selon l'une des revendications précédentes, **caractérisé en ce que** les éléments magnétorésistifs de détecteur (22, 24, 26) sont configurés comme éléments à vanne de spin GMR.

5. Détecteur de champ magnétique selon l'une des revendications précédentes, **caractérisé en ce que** les éléments de détecteur (22, 24, 26) présentent tous quatre résistances de mesure raccordées en pont de Wheatstone.

6. Détecteur de champ magnétique selon l'une des revendications précédentes, **caractérisé en ce que** l'élément de mesure (22) de la puce de détecteur (14) est disposé dans le plan de symétrie (M) de l'aimant permanent (10).

7. Détecteur de champ magnétique selon l'une des revendications précédentes, **caractérisé en ce que** tous les éléments de détecteur (22, 24, 26) sont disposés sur une puce de détecteur (14) dans un plan (20) situé au-dessus du plan (22) du circuit d'évaluation.
